# EUROPÄISCHE PATENTSCHRIFT

(11) **EP 1 495 166 B1**
(45) Veröffentlichungstag und Bekanntmachung des Hinweises auf die Patenterteilung: **09.05.2007**
(21) Anmeldenummer: 03727146.7
(22) Anmeldetag: 21.03.2003
(51) Int. Cl.: C30B 13/00, C30B 11/00, C30B 13/24, C30B 29/52

(54) **VERFAHREN ZUM HERSTELLEN VON EINKRISTALLINEN STRUKTUREN**
METHOD FOR PRODUCING FOR PRODUCING MONO-CRYSTALLINE STRUCTURES
PROCEDE DE PRODUCTION DE STRUCTURES MONOCRISTALLINES

(30) Priorität: 15.04.2002 DE 10216662; 19.09.2002 DE 10243558
(43) Veröffentlichungstag der Anmeldung: 12.01.2005
(73) Patentinhaber: SIEMENS AKTIENGESELLSCHAFT, 80333 München (DE)
(72) Erfinder: BECK, Thomas, 16341 Zepernick (DE); BOSTANJOGLO, Georg, 12161 Berlin (DE); COX, Nigel-Philip, 10119 Berlin (DE); WILKENHÖNER, Rolf, 10589 Berlin (DE)
(86) Internationale Anmeldenummer: PCT/DE2003/000952
(87) Internationale Veröffentlichungsnummer: WO 2003/087439

(56) Entgegenhaltungen:
- EP-A- 0 740 977
- EP-A- 0 861 927
- EP-A- 1 065 026
- US-A- 4 707 217
- US-A- 6 024 792
- US-A- 6 103 402
- YANG S ET AL: "EFFECTS OF CRYSTAL ORIENTATION ON MICROSTRUCTURE OF MOLTEN POOL IN LASER RAPIDLY SOLIDIFIED DD2 SINGLE CRYSTAL" JOURNAL OF MATERIALS SCIENCE LETTERS, CHAPMAN AND HALL LTD. LONDON, GB, Bd. 21, Nr. 1, 1. Januar 2002 (2002-01-01), Seiten 1-6, XP001081518 ISSN: 0261-8028

## Beschreibung

Die Erfindung bezieht sich auf ein Verfahren zum Herstellen von gerichtet erstarrten und einkristallinen Strukturen, insbesondere aus Superlegierungen nach dem Oberbegriff des unabhängigen Anspruchs 1.

Metallische Werkstücke mit einkristalliner Struktur oder Strukturen werden als Bauteile von Maschinen verwendet, die im Betrieb hohen mechanischen, thermischen und/oder chemischen Belastungen ausgesetzt sind. Beispielsweise werden Schaufeln von Gasturbinen, insbesondere auch von Rotoren für Flugzeug-Triebwerke, aber auch solche für stationäre Gasturbinen, aus Einkristallen hergestellt.
Die Fertigung von derartigen einkristallinen Werkstücken erfolgt z.B. durch gerichtetes Erstarren aus der Schmelze. Es handelt sich dabei um Giessverfahren, bei denen die flüssige metallische Legierung zur einkristallinen Struktur, d.h. zum einkristallinen Werkstück, oder gerichtet erstarrt.
Es ist beispielsweise ein spezielles Giessverfahren zum Herstellen derartiger Werkstücke bekannt, bei dem die in einer keramischen Form befindliche flüssige Legierung in einem gerichteten Temperaturfeld, z.B. eines Bridgemanofens, eine Kristallorientierung erhält. Dabei werden dendritische Kristalle entlang dem Wärmefluss ausgerichtet und bilden entweder eine stängelkristalline Kornstruktur (d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall.
In diesen Verfahren muss man den Übergang zur globulitischen (polykristallinen) Erstarrung meiden, da dieses ungerichtete Wachstum notwendigerweise transversale und longitudinale Korngrenzen ausbildet, welche die guten Eigenschaften des gerichtet erstarrten oder einkristallinen Bauteiles zunichte machen.
Wenn in der vorliegenden Schrift von einkristalliner Struktur und einkristallinen Strukturen die Rede ist, so sind damit sowohl Einkristalle, die keine Korngrenzen aufweisen, als auch Kristallstrukturen, die wohl Korngrenzen, die longitudinal verlaufen, aber keine Korngrenzen, die in transversaler Richtung verlaufen, aufweisen. Bei diesen zweitgenannten kristallinen Strukturen spricht man auch von gerichtet erstarrten Gefügen (directionally solidified structures).

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen.

Als Legierungen beispielsweise für die erwähnten Einkristall-Turbinenschaufeln, werden u.a. sog. Superlegierungen auf Nickel- (Ni), Kobalt- (Co) oder Eisenbasis (Fe) verwendet. Besonders Superlegierungen auf Nickelbasis haben hervorragende mechanische und chemische Hochtemperatureigenschaften.

Solche Bauteile nutzen sich im Einsatz ab und werden beschädigt, können aber wieder aufgearbeitet werden, indem man die betroffenen Bereiche falls nötig entfernt und neues Material in diesen Bereichen wieder aufträgt (bspw. epitaktisch). Dabei soll aber wieder die gleiche Kristallstruktur erreicht werden.
Ein solches Verfahren ist in der US-PS 6,024,792 und in der EP 0 892 090 A1 gezeigt.
Bei diesem Verfahren wird eine Schicht des aufzutragenden Materials quer zu Länge der zu behandelnden Oberfläche jeweils in schmalen Bahnen, die der Bereich der zu behandelnden Oberfläche entsprechen, nebeneinander aufgetragen. Dadurch kommt es zur Überlappung oder Berührung einzelner Schweissraupen (Bahnen, auf denen nebeneinander neues Material aufwächst), die wegen der geometrischen Verhältnisse zu nicht epitaktischem Aufwachsen mit ungenügender Kristallausrichtung führen.
In der Folge sind die mechanischen Eigenschaften mangelhaft.

Es ist daher Aufgabe der Erfindung, den oben genannten Nachteil zu überwinden.

Die Aufgabe wird durch ein Verfahren gemäß Anspruch 1 gelöst.

Mit dem neuartigen Verfahren ist es möglich, auf der beispielsweise gerichtet erstarrten Struktur eines Substrats eine oder mehrere Schichten, bzw. einen Körper oder ein Werkstück mit der gleichen gerichtet erstarrten Struktur wie das Substrat in einer Bahn aufzubauen. Es handelt sich um ein epitaktisches Verfahren (epitaktisch nennt man das gleichorientierte Kristallwachstum auf einer kristallinen Unterlage), bei welchem die gerichtete kristalline Struktur des Substrates, von der Schicht oder den Schichten, die aufgebaut werden, übernommen wird. Dabei muss durch eine entsprechende Prozesskontrolle ein globulitisches Gefüge vermieden werden.

Die Erfindung schafft ein neuartiges Verfahren, mit dem es möglich ist, auf einem Substrat mit einkristalliner Struktur, bzw. einkristallinen Strukturen eine oder mehrere Schichten, bzw. einen Körper oder ein Werkstück mit einkristalliner Struktur aufzubauen. Es handelt sich dabei um ein epitaktisches Verfahren, bei welchem die kristalline Struktur des Substrates von der Schicht oder den Schichten, die aufgebaut werden, übernommen wird.

Bisher gab es keine Möglichkeit, ein einkristallines Werkstück so zu reparieren bzw. zu rekonditionieren, dass das einkristalline Gefüge des Grundwerkstoffes auch in der rekonditionierten Stelle vorliegt, ohne dass dabei viele unerwünschte Kristallausrichtungen auftreten.
Mit dem neuen Verfahren ist es nun möglich, beschädigte und abgenutzte einkristalline Werkstücke einkristallin zu rekonditionieren, d.h. die optimale Kristallstruktur zu ergänzen und neu aufzubauen. Dabei wird auf dem Substrat, bei z.B. einer einkristallinen Rotorschaufel Schicht um Schicht auf einer Bahn einkristallin auf- und weitergebaut bis die ursprüngliche Grösse und Form des Werkstücks wieder erreicht ist. Das Überstreichen in Längsrichtung der zu behandelnden Oberfläche des Werkstücks erfolgt dabei jeweils in einem einzigen kontinuierlichen Zug, also ohne mäanderartige Querbewegungen zur Erzeugung schmaler, sich in Längsrichtung überlappender Einzelschweißraupen.

Das Verfahren für den Aufbau von Einkristallen aus dem gleichen Werkstoff, angenähert gleichen oder verschiedenen Werkstoffen wie das Substrat, ermöglicht beispielsweise den Neuaufbau bzw. die Ergänzung von Werkstücken, die einkristalline Strukturen aufweisen und die beschädigt sind oder abgenutzt sind. Beispielsweise gibt es heute Rotorschaufeln von Gasturbinen, die aus Einkristallen von sog. metallischen Superlegierungen bestehen und die mit dem Verfahren repariert werden können, wenn sie beschädigt sind.

Einkristalline Werkstücke können zwar aus der Schmelze durch sog. gerichtetes Erstarren (directionally solidified) hergestellt werden. Aber auch solche mit gerichtetem Erstarren hergestellte Teile nützen sich ab.
Mit dem neuen Verfahren ist es nun auch möglich, beschädigte und abgenutzte einkristalline Werkstücke einkristallin zu rekonditionieren, d.h. die Kristallstruktur zu ergänzen und neu aufzubauen. Dabei wird auf dem Substrat, bei z.B. einer einkristallinen Rotorschaufel Schicht um Schicht einkristallin auf- und weitergebaut bis die ursprüngliche Grösse und Form des Werkstücks wieder erreicht ist.

Als Energie- bzw. Wärmequelle für das Durchführen des Verfahrens sind Laserstrahlen oder Elektronenstrahlen geeignet, also Energiequellen, mit denen es möglich ist, auf einer grossen Fläche, bzw. in einem grossen Volumen hohe Energiemengen einzubringen.

Der Strahl hoher Energie und Energiedichte wird auf die Oberfläche des Substrats gerichtet, so dass eine Oberflächenschicht des Substrats leicht anschmilzt. Dem Arbeitsbereich des Strahls wird das Material bspw. in Pulverform oder in Form eines Drahts zugeführt. Das zugeführte Material wird ebenfalls geschmolzen. Das Schmelzen dieses zugeführten Materials kann im Flüssigbad der geschmolzenen Oberflächenschicht oder schon auf dem Weg zum Flüssigbad erfolgen. Der Vorgang läuft vorzugsweise unter Schutzgas und/oder im Vakuum ab.

Wenn nun das Erstarren der Schmelze unter Bedingungen abläuft, die ausserhalb des globulitischen Bereichs, also im Bereich, in welchem das verwendete Material gerichtet erstarrt, liegt, erstarrt der Werkstoff in einkristalliner Form, wächst also als epitaktische Struktur auf dem Substrat. Bei Metallen spricht man von globulitischer Erstarrung, wenn die Schmelze nicht gerichtet kristallisiert. Es bilden sich dann beim Übergang von "gerichtet einkristallin" auf "ungerichtet" notwendigerweise eine oder mehrere Korngrenzen aus, welche die Vorteile des Einkristalls zunichte machen.

Die einkristalline Struktur wird in Form von dünnen Schichten, Platten oder komplexen Formen von etwa einem Millimeter oder einem Bruchteil eines Millimeters übereinander Schicht für Schicht aufgetragen.
Wenn das Substrat z.B. durch Blindspuren, d.h. ohne Materialzufuhr, mit dem Laser oder induktiv auf eine Vorwärmtemperatur im Bereich von 600°C bis 1100°C gebracht wird und diese Temperatur z.B. während dem Aufbau aufrecht erhalten wird, werden die Spannungen im Substrat und im aufgebauten Einkristall, aber auch zwischen dem Substrat und der epitaktisch darauf aufgebauten kristallinen Struktur verringert, was zum Verhindern von Rekristallisation und Kriechen in der Kristallstruktur beiträgt.

Entspannungsglühen von Substrat und neu aufgebauter Einkristallschicht während etwa einer Stunde bei einer Temperatur im Bereich von etwa 1000°C bis 1250°C, für CMSX-4 bei ca. 1150°C und nachfolgendem langsamen Abkühlen reduziert innere Spannungen, welche zur Zerstörung der einkristallinen Strukturen durch Rekristallisation und Kriechen führen könnten. Das Spannungsarmglühen könnte aber auch gleich nach dem Aufbringen der epitaktischen Schicht mit einer HF-Einrichtung erfolgen.

Das sogenannte GV-Diagramm ist für verschiedene Metalle und metallische Legierungen unterschiedlich und kann für jede Legierung berechnet oder experimentell bestimmt werden. Die Kurve L trennt im GV-Diagramm den Bereich der beiden Parameter Erstarrungsgeschwindigkeit und Temperaturgradient, in welchem die Legierung globulitisch erstarrt, von jenem in welchem die Legierung zu einem dendritisch gerichteten Gefüge erstarrt. Eine Beschreibung und Erklärung des GV-Diagramms findet sich z.B. in Material Science Engineering Band 65 1984, in der Publikation J. D. Hunt über "Columnar to Equiangular Transition".

Ausführungsbeispiele sind in den Figuren gezeigt.
Figur 1 zeigt eine Intensitätsverteilung in Querschnitten eines Brennfleckes, der für das erfindungsgemäße Verfahren verwendet wird,
Figur 2 einen Brennfleck auf einem Bauteil, bei dem das erfindungsgemäße Verfahren angewendet wird,
Figur 3 einen Strahlfleck und den Brennfleck,
Figur 4 eine Intensitätsverteilung in einem Querschnitt eines Brennfleckes, der für das erfindungsgemäße Verfahren verwendet wird, und
Figur 5 ein Verfahrensablauf nach dem Stand der Technik.

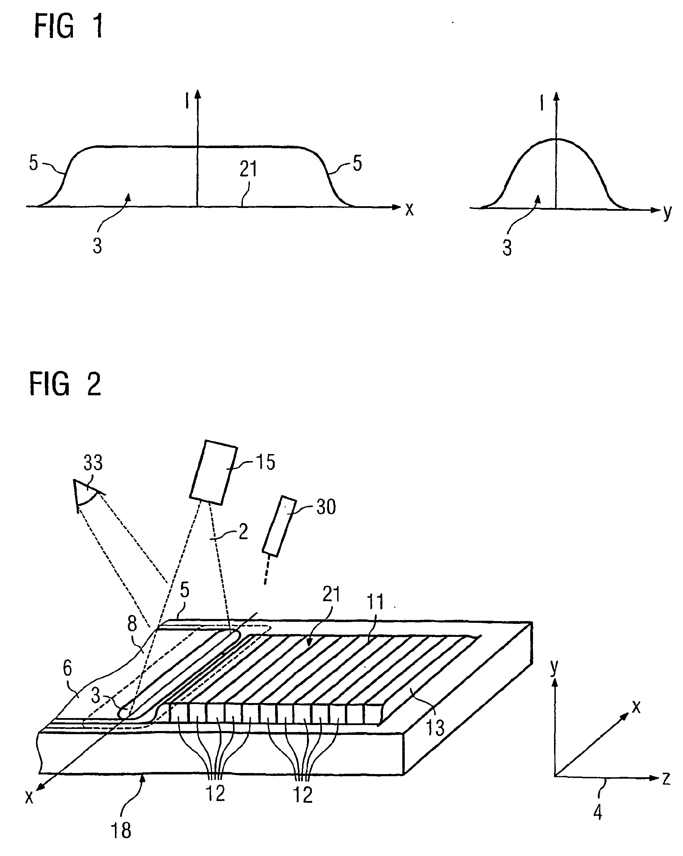

Figur 1 zeigt die Intensitätsverteilung des Strahles 2 (Fig. 2) einer Energiequelle in einem Brennfleck 3 in einer Ebene, wobei dieser nicht kreisförmig ist, sondern in x- und y-Richtung verschieden breit ausgebildet ist.
Die x-Richtung wird im folgenden als Breite bezeichnet. Die z-Richtung entspricht einer Vorschubrichtung 4 (Fig. 2).
Die Ebene (x-z-Ebene) entspricht der zu behandelnden Oberfläche 21 eines Bauteils 6 (Fig. 2).

In x-Richtung weist der Strahl 2 bspw. ein nahezu rechteckförmiges Profil der Intensitätsverteilung auf.
An den Profilenden 5 des Strahles in x-Richtung ist beispielsweise ein gekrümmter Übergang vorhanden, der bspw. technisch bedingt ist. In x-Richtung kann auch nahezu rechteckiges Profil vorhanden sein.

In y-Richtung weist die Intensitätsverteilung des Brennflecks 3 bspw. eine im wesentlichen umgekehrt parabelförmige Form auf, die bspw. auch technisch bedingt ist.
In y-Richtung kann auch nahezu rechteckiges Profil vorhanden sein.

Figur 2 zeigt den Brennfleck 3, der durch einen Energieeintrag mittels des Strahls 2 der Energiequelle 15 auf dem Bauteil 6 erzeugt wird.
Das Bauteil 6 weist ein Substrat 18 auf.
Das Substrat 18 hat bspw. ein gerichtet erstarrtes Gefüge. Der Brennfleck 3 wird mit einer bestimmten Geschwindigkeit in Vorschubrichtung 4 (z-Richtung) auf einer Bahn 5 (Bereich, auf dem Material 13 aufgebracht ist / wird, durch eine Linie angedeutet) über das Bauteil 6 geführt.

Über eine Materialzuführung 30 wird Material 13 bspw. in Form von Pulver zugeführt. Es können auch mehrere Materialzuführungen 30 verwendet werden.
Die Materialzuführung 30 kann die Zufuhr von Material 13 zeitlich und örtlich sowie in ihrer Zusammensetzung variieren.

Das Substrat 18 wird an einer zu behandelnden Oberfläche 21 des Bauteils 6 bspw. mit auf- und umgeschmolzen.
Diesem flüssigen, geschmolzenen Bad wird Material 13 z.B. als Draht, Blech oder Pulver zugeführt.
Das zugeführte Material 13, das eine mono- oder polykristalline Struktur haben kann, wird in das aufgeschmolzenen Grundmaterial in die Umschmelzzone eingebracht und vollständig geschmolzen.
Dieses zugeführte Material 13, also z.B. das geschmolzene Pulver, kann dann zu einer Schicht in Form eines Einkristalls oder eines einkristallinen Gefüges mit einkristallinen Dendriten, d.h. zu einem dendritischen Einkristall erstarren.
Es kann aber auch schon vor dem Aufschmelzen Material 13 auf der Oberfläche 21 vorhanden sein, das dann mit einem Teil der Oberfläche 21 des Substrats 18 aufgeschmolzen wird.

Es gibt daher Bereiche 8 des Bauteils 6, die mittels des erfindungsgemäßen Verfahrens schon bearbeitet wurden.

In Vorschubrichtung 4 des Laserstrahls 2 gibt es noch Bereiche 11, die mittels des erfindungsgemäßen Verfahrens noch hergestellt werden müssen.
In diesem Bereich 11 ist Material 13 aufgebracht oder wird hinzugefügt, das aufgeschmolzen wird und entsprechend dem erfindungsgemäßen Verfahren erstarrt. Das zugeführte Material 13, das eine mono- oder polykristalline Struktur haben kann, wird in den Bereich des Brennflecks 3 gebracht und vollständig aufgeschmolzen.
Ebenso wird dabei die Oberfläche 21 des Bauteils 6 erwärmt, auf dem das Material 13 aufgeschmolzen wird.

Der Brennfleck 3 mit seiner etwa bspw. rechteckförmigen Querschnittfläche wird in Vorschubrichtung 4 über das Material 13 geführt.
Die Breite (x-Richtung) des Brennflecks 3 wird bspw. der Breite des Bereiches angepasst, der mit Material aufgefüllt werden soll und ist in etwa so breit wie die Ausdehnung des auffüllenden Materials 13 in x-Richtung, so dass in einer einzigen kontinuierlichen Vorschubbewegung eine vollständige Überstreichung der zu behandelnden Oberfläche 21 zur Auftragung einer zusammenhängenden Schicht aus dem Material 13 erfolgt.

Der Brennfleck 3 und damit auch der aufgeschmolzene Bereich können ebenso linienförmig (d.h. gemessen an der Längsausdehnung sehr schmal) oder elliptisch ausgebildet sein.
Solche Brennflecke 3 lassen sich z. B. von Slab-Lasern erhalten.
Weitere Möglichkeiten der Erzeugung dieser geeigneten Brennfleckgeometrie sind gegeben durch Anordnung von Lichtleitfasern (fiber arrays), geeignete Strahltransformationsoptiken, Diodenstapel und evtl. kompaktierende beispielsweise trichterförmig ausgeprägte Optiken.

In den seitlichen Randbereichen 5 des Strahlquerschnitts wird kein Material 13 eingebracht.
Je breiter der zentrale Bereich des rechteckigen Brennflecks 3 ist, desto breiter wird die von dem aufgebrachten Material 13 gebildete Raupe.
Durch geeignete Maßnahmen kann die Breite variiert werden. Dies geschieht bspw. durch eine entsprechende Optik des Lasers 15.

Das Material 13 wird bspw. pulverförmig in Linien 12 längs der x-Richtung aufgetragen. Alle Linien 12 bilden die Raupe, also eine neue zu bildende Schicht auf dem Substrat 18.

Nach dem Stand der Technik wird der Strahl 2 in x-Richtung für jede Linie 12 mäanderförmig hin- und herbewegt und erst dann schrittweise in Vorschubrichtung 4 (z-Richtung) bewegt. Mit dem erfindungsgemässen kann die Mäanderförmige Hin- und Herbewegung entfallen. Das vereinfacht auch die Strahlführung oder die Bewegung der Energiequelle 15 bzw. des Bauteils 6.

Außerdem kann die Leitung so geregelt werden, dass die Leistungsdichte im zentralen Bereich des Brennflecks 3 konstant bleibt. So lassen sich Raupen während der Bewegung des Brennflecks 3 verschiedener oder variabler Breite generieren.

Durch das erfindungsgemäße Verfahren lassen sich breite Schweissraupen epitaktisch aufbringen. Durch Wiederholung des Verfahrens lassen sich schichtweise beliebig dicke Strukturen Raupe für Raupe aufbauen, ohne das durch seitliche, d.h. längs der x-Richtung, Überlappung die Materialeigenschaften herabgesetzt werden.

Es ist zu beachten, dass das Wachsen einer monokristallinen Schicht voraussetzt, dass das zugeführte Material 13 vollständig aufgeschmolzen wird. Wenn dies nicht der Fall ist, bilden z.B. nicht vollständig geschmolzene Pulverkörner Kristallisationskerne für Dendriten und Kristalle, welche das 2einkristalline Wachstum der Struktur stören und zerstören.

Beim Aufbau einer grösseren Struktur, bzw. eines grösseren Körpers mit dem epitaktischen Verfahren, bilden sich an der Oberfläche der zuletzt hergestellten Schicht globulitische Bezirke. Diese "equiaxed grains" sind Keime, welche das gerichtete Wachstum der Kristalle stören oder unterbrechen.

Beim Aufbau der nächsten, darrüberliegenden Schicht ist es demnach von grosser Wichtigkeit, dass diese Globuliten vollständig aufgeschmolzen werden, so dass Dendriten, welche das monokristalline Gefüge zerstören würden verschwinden bzw. unter der Oberfläche gar nicht entstehen.

Andere Superlegierungen, mit denen sich nach dem Verfahren der vorliegenden Erfindung einkristalline Strukturen aufbauen lassen, sind beispielsweise IN 738LC, IN 939, IN 100, B 1914, CM 99, SRR 99, CM-247 LC, CMSX-2, CMSX-3, CMSX-6, Mar-M002

Das Verfahren bspw. mit einem Elektronenstrahl als Energiequelle wird im Vakuum durchgeführt. Auch mit einem Laser als Energiequelle könnte das Verfahren im Vakuum durchgeführt werden. Im Vakuum ist zwar kein Schutzgas erforderlich, dafür kann das Manipulieren von Energiequelle, Substrat und zuzuführendem Werkstoff Probleme bringen.

Eine Temperaturkontrolle kann über eine Optik 33 erfolgen, die bestimmt, wann die nächste epitaktische Schicht gebildet werden soll.

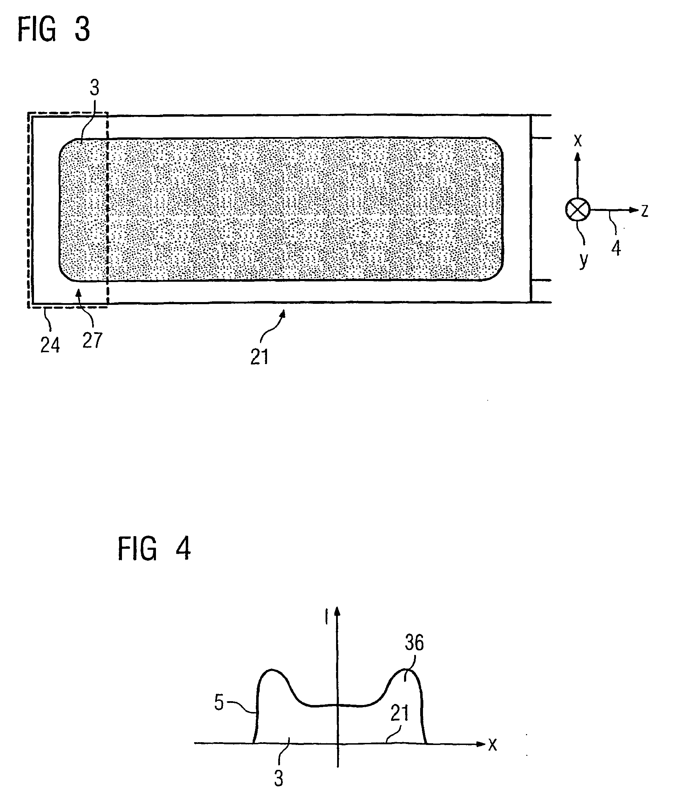

Figur 3 zeigt den bestrahlten Bereich 24, der von dem Energiestrahl 2 bedeckt ist (gestrichelt umrandet).
Der Bereich 24 wird über die Oberfläche 21 gefahren.
Es gibt dann einen inneren Bereich (grau), der den gesamten erzeugten Brennfleck 3 zeigt, der durch Abfahren des Energiestrahls entstand und einen äusseren Bereich 27, der zwar vom Energiestrahl 2 bestrahlt wurde, wo aber die Energie zu gering war, um einen Brennfleck 3 (Material geschmolzen) zu erzeugen.
An den kleineren Stirnseiten des Brennflecks 3 wird eine gleichmässige, konstante Energieverteilung erreicht.
Dies ist bei den bisher üblichen kreisförmigen Brennflecken nicht der Fall.
Der rechteckförmige Brennfleck 3 ist also der Kontur des aufzuschmelzenden Bereichs angepasst.

Durch geeignete verstell- oder steuerbare Optiken kann der Strahlquerschnitt während der Bearbeitung auf Wunschbreite eingestellt werden.
Ebenso kann durch einen Rechner zeitgleich die Laser-Leistung angepasst werden.
Eine bspw. weitere vorgeschaltete Optik kann die optimale Breite des aufzuschmelzenden Bereichs erfassen und in-situ an die Energiequelle 15 weiterleiten, d.h. es kann erfasst werden, wie breit der Brennfleck 3 sein muss.
Insbesondere lässt sich dadurch ein Überlapp von nebeneinander angeordneten Bereichen 8 vermeiden. Die Berührung eines bereits kristallin gewachsenen Bereichs mit einem aufgeschmolzenen Bereich kann zur Fehlorientierung führen.
Dies kann mit dem erfindungsgemässen Verfahren vermieden werden, indem der mit Material 13 aufzufüllende Bereich auf der Oberfläche 21 durch eine einzige Bewegung in z-Richtung aufgefüllt wird. In y-Richtung lässt sich das Verfahren mehrmals wiederholen; dabei erfolgt also ein schichtweises Auftragen und Aufschmelzen.

Ggf. ist auch ein Überlapp möglich, wenn die Linien 12 in x-Richtung wie beim Stand der Technik abgefahren werden. Jedoch wird durch den erfindungsgemässen Brennfleck 3 gegenüber dem Stand der Technik an den kleineren Stirnseiten des Brennflecks 3 eine gleichmässige, konstante Energieverteilung in x-Richtung erreicht.

Der Laser mit seiner Laserwellenlänge wird so ausgewählt, dass das Werkstück die Energie des Laserstrahls stark absorbiert und/oder schwächer reflektiert. Dies ist z. B. der Fall bei Nd:YAG-Lasern mit einer Wellenlänge von 1,06µm und bei Hochleistungsdiodenlasern (0,81 µm; 0.94µm).

Figur 4 zeigt eine weitere Intensitätsverteilung des Strahles (Brennfleck 3) in x-Richtung.

In x-Richtung weist der Brennfleck 3 an den Profilenden 5 eine Erhöhung 36 der Intensität des Energieeintrag der Energiequelle 15 gegenüber dem mittleren Bereich des Brennflecks 3 auf.
So können Oberflächenspannungseffekte kompensiert werden.

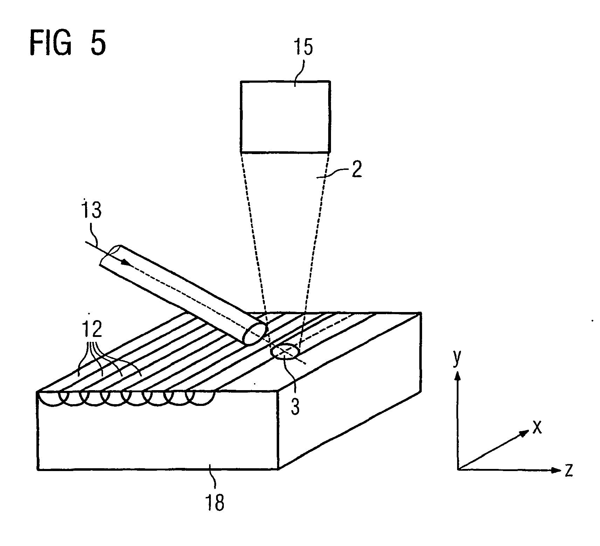

Figur 5 zeigt den Verfahrensablauf nach dem Stand der Technik.
Bei dem Verfahren nach dem Stand der Technik wird eine Schicht des aufzutragenden Materials quer zu Länge (in x-Richtung) der zu behandelnden Oberfläche (11) jeweils in schmalen Bahnen (12), die der Bereich der zu behandelnden Oberfläche entsprechen, nebeneinander aufgetragen.
Dadurch kommt es zur Überlappung oder Berührung einzelner Schweissraupen (Bahnen, auf denen nebeneinander neues Material aufwächst), die wegen der geometrischen Verhältnisse zu nicht epitaktischem Aufwachsen mit ungenügender Kristallausrichtung führen.
Der runde Laserstrahl 2 erzeugt einen runden Brennfleck 3. Der Laserstrahl 2 bewegt sich also in x-Richtung immer wieder hin und her und schrittweise in z-Richtung vorwärts.

## Patentansprüche

1. Verfahren zum Herstellen von metallischen einkristallinen Strukturen, metallischen einkristallinen Teilen oder metallischen einkristallinen Werkstücken,
auf Substraten (18)
durch epitaktisches Aufwachsen,
wobei durch einen Energieeintrag einer Energiequelle (15) mittels eines Brennflecks (3) der Energiequelle (15) eine zu behandelnde Oberfläche (11) des Bauteils (6) aufgeschmolzen wird,
wobei dem geschmolzenen Bereich Material (13) zugeführt wird, und
wobei das zugeführte Material (13) vollständig aufgeschmolzen wird,
oder zugeführtes Material (13) mit der Oberfläche (11) aufgeschmolzen wird,
wobei das aufgeschmolzene Material in die einkristalline Struktur gebracht werden kann, und
wobei das aufgeschmolzene Material erstarren gelassen wird,
**dadurch gekennzeichnet,**
**dass** der Brennfleck (3) eine linienförmige, elliptische oder rechteckige Geometrie aufweist.

2. Verfahren nach Anspruch 1,
**dadurch gekennzeichnet, dass**
der Energieeintrag durch einen Laser (15) erfolgt.

3. Verfahren nach Anspruch 1,
**dadurch gekennzeichnet, dass**
der Energieeintrag durch Elektronenstrahlen erfolgt.

4. Verfahren nach Anspruch 1,
**dadurch gekennzeichnet, dass**
der Brennfleck (3),
der durch den Energieeintrag erzeugt wird,
um einen aufgeschmolzenen Bereich mit linienförmiger, elliptischer oder rechteckiger Geometrie zu erzeugen.

5. Verfahren nach Anspruch 1,
**dadurch gekennzeichnet, dass**
die Grösse des Brennflecks (3) während des Verfahrens verändert wird.

6. Verfahren nach Anspruch 1,
**dadurch gekennzeichnet,**
**dass** der Brennfleck (3) Profilenden (5) aufweist, und
**dass** die Intensität des Energieeintrags an den Profilenden (5) gegenüber dem mittleren Bereich des Brennflecks (3) erhöht (36) wird.

7. Verfahren nach Anspruch 1,
**dadurch gekennzeichnet,**
**dass** die Zufuhr von Material über zumindest eine Materialzuführung (30) erfolgt, und
**dass** die Materialzufuhr zeitlich und örtlich variiert wird.

8. Verfahren nach Anspruch 1,
**dadurch gekennzeichnet, dass**
die Temperatur des Brennflecks (3) kontrolliert wird.

9. Verfahren nach Anspruch 1 oder 5,
**dadurch gekennzeichnet,**
**dass** der Brennfleck (3) in einer Vorschubrichtung (4) über das Substrat (18) bewegt wird,
**dass** das Substrat (18) einen Bereich aufweist,
dem Material (13) hinzugefügt wird, und
**dass** der Brennfleck (3) der Geometrie dieses Bereichs derart angepasst ist,
**dass** quer zur Vorschubrichtung (4) eine Breite des Brennflecks (3) der Breite dieses Bereichs angepasst ist.

10. Verfahren nach Anspruch 1
**dadurch gekennzeichnet,**
**dass** der Brennfleck (3) in einer Vorschubrichtung (4) über das Substrat (18) bewegt wird,
**dass** die Vorschubrichtung (4) in Richtung der Längsausdehnung der zu behandelnden Oberfläche (11) liegt, und dass die Energiequelle (15) einen Brennfleck (3) erzeugt,
dessen Abmessung quer zur Vorschubrichtung (4) der gesamten Breite der zu behandelnden Oberfläche (11) entspricht und
in einer einzigen kontinuierlichen Vorschubbewegung eine vollständige Überstreichung der zu behandelnden Oberfläche (11) zur Auftragung einer zusammenhängenden Schicht aus dem Material (13) erfolgt.

11. Verfahren nach Anspruch 1,
**dadurch gekennzeichnet, dass**
das Verfahren mit metallischen Superlegierungen durchgeführt wird.

12. Verfahren nach Anspruch 1,
**dadurch gekennzeichnet, dass**
das Verfahren mit Substraten durchgeführt wird, die eine einkristalline Struktur oder einkristalline Strukturen aufweisen.

## Claims

1. Method for producing monocrystalline structures, parts or workpieces,
on substrates (18)
by epitaxial growth,
a surface (11) to be treated of the component (6) being melted by an energy input of an energy source (15) by means of a focal spot (3) of the energy source (15),
material (13) being fed to the molten area, and
the fed material (13) being melted completely,
or fed material (13) being melted with the surface (11),
it being possible for the molten material to be brought into the monocrystalline structure, and
the molten material being left to solidify,
**characterized**
**in that** the focal spot (3) has a linear, elliptical or rectangular geometry.

2. Method according to Claim 1,
**characterized in that**
the energy input takes place by a laser (15).

3. Method according to Claim 1,
**characterized in that**
the energy input takes place by electron beams.

4. Method according to Claim 1,
**characterized in that**
the focal spot (3),
which is produced by the energy input,
to produce a molten area with a linear, elliptical or rectangular geometry.

5. Method according to Claim 1,
**characterized in that**
the size of the focal spot (3) is changed during the method.

6. Method according to Claim 1,
**characterized**
**in that** the focal spot (3) has profile ends (5), and
**in that** the intensity of the energy input is increased at the profile ends (5) as compared with the middle area of the focal spot (3).

7. Method according to Claim 1,
**characterized**
**in that** the feed of material takes place by means of at least one material feed (30), and
**in that** the material feed is varied in terms of time and location.

8. Method according to Claim 1,
**characterized in that**
the temperature of the focal spot (3) is controlled.

9. Method according to Claim 1 or 5,
**characterized**
**in that** the focal spot (3) is moved over the substrate (18) in a direction of advancement (4),
**in that** the substrate (18) has an area
to which material (13) is added, and
**in that** the focal spot (3) is adapted to the geometry of this area in such a way
that a width of the focal spot (3) is adapted to the width of this area transversely in relation to the direction of advancement (4).

10. Method according to Claim 1,
**characterized**
**in that** the focal spot (3) is moved over the substrate (18) in a direction of advancement (4),
**in that** the direction of advancement (4) lies in the direction of the linear extent of the surface (11) to be treated,
and **in that** the energy source (15) produces a focal spot (3)
the dimension of which transversely in relation to the direction of advancement (4) corresponds to the entire width of the surface (11) to be treated and
a complete pass over the surface (11) to be treated for applying a coherent layer of the material (13) takes place in a single continuous advancing movement.

11. Method according to Claim 1,
**characterized**
**in that** the method is carried out with metal superalloys.

12. Method according to Claim 1,
**characterized**
**in that** the method is carried out with substrates which have a monocrystalline structure or monocrystalline structures

## Revendications

1. Procédé de production de structures, parties ou pièces monocristallines,
sur des substrats (18)
par croissance épitaxiale,
dans lequel on fait fondre par un apport d'énergie d'une source (15) d'énergie, au moyen d'une tache (3) focale de la source (15) d'énergie, une surface (11) à traiter de l'élément (6) constitutif
dans lequel on apporte de la matière (13) à la zone fondue et
dans lequel on fait fondre complètement la matière (13) apportée
ou on fait fondre de la matière (13) apportée avec la surface (11),
dans lequel on peut mettre la matière apportée sous la forme de la structure monocristalline et
dans lequel on laisse se solidifier la matière fondue,
**caractérisé**
**en ce que** la tache (3) focale a une géométrie linéaire, elliptique ou rectangulaire.

2. Procédé suivant la revendication 1,
**caractérisé en ce que**
l'on effectue l'apport d'énergie par un laser (15).

3. Procédé suivant la revendication 1,
**caractérisé en ce que**
l'on effectue l'apport d'énergie par un faisceau d'électrons.

4. Procédé suivant la revendication 1,
**caractérisé en ce que**
la tache (3) focale,
qui est produite par l'apport d'énergie,
pour produire une zone fondue de géométrie linéaire, elliptique ou rectangulaire.

5. Procédé suivant la revendication 1,
**caractérisé en ce que**
l'on modifie la dimension de la tache (3) focale pendant le procédé.

6. Procédé suivant la revendication 1,
**caractérisé en ce que**
la tache (3) focale a des extrémités (5) de profil et
**en ce que** l'intensité de l'apport d'énergie aux extrémités (5) de profil est plus grande que dans la zone médiane de la tache (3) focale.

7. Procédé suivant la revendication 1,
**caractérisé en ce que**
l'on effectue l'apport de matière par au moins un conduit (30) d'apport de matière et
**en ce que** l'on modifie dans le temps et dans l'espace l'apport de matière.

8. Procédé suivant la revendication 1,
**caractérisé en ce que**
l'on contrôle la température de la tache (3) focale.

9. Procédé suivant la revendication 1 ou 5,
**caractérisé en ce que**
l'on déplace la tache (3) focale dans une direction (4) d'avance sur le substrat (18),
**en ce que** le substrat (18) a une zone,
à laquelle est ajoutée de la matière (13) et
**en ce que** l'on adapte la tache (3) focale à la géométrie de cette zone de façon
à ce qu'une largeur de la tache (3) focale, transversalement à la direction (4) d'avance, soit adaptée à la largeur de cette zone.

10. Procédé suivant la revendication 1,
**caractérisé**
**en ce que** l'on déplace la tache (3) focale dans une direction (4) d'avance au-dessus du substrat (18),
**en ce que** la direction (4) d'avance se trouve dans la direction de l'étendue longitudinale de la surface (11) à traiter,
et **en ce que** la source (15) d'énergie produit une tache (3) focale,
dont la dimension transversalement à la direction (4) d'avant correspond à toute la largeur de la surface (11) à traiter et
on effectue dans un mouvement d'avance unique continu un balayage complet de la surface (11) à traiter pour déposer une couche d'un seul tenant en la matière (13).

11. Procédé suivant la revendication 1,
**caractérisé en ce que**
l'on effectue le procédé avec des superalliages métalliques.

12. Procédé suivant la revendication 1,
**caractérisé en ce que**
l'on effectue le procédé avec des substrats qui ont une structure monocristalline ou des structures monocristallines.
